# EUROPEAN PATENT SPECIFICATION

(11) **EP 2 016 583 B1**
(45) Date of publication and mention of the grant of the patent: **15.08.2012**
(21) Application number: 07728246.5
(22) Date of filing: 18.04.2007
(51) Int. Cl.: G10L 19/00, G10L 19/14

(54) **METHOD AND APPARATUS FOR LOSSLESS ENCODING OF A SOURCE SIGNAL, USING A LOSSY ENCODED DATA STREAM AND A LOSSLESS EXTENSION DATA STREAM**
VERFAHREN UND VORRICHTUNG ZUR VERLUSTLOSEN CODIERUNG EINES QUELLENSIGNALS UNTER VERWENDUNG EINES VERLUSTBEHAFTET CODIERTEN DATENSTROMS UND EINES VERLUSTLOSEN ERWEITERUNGSDATENSTROMS
PROCEDE ET APPAREIL POUR UN CODAGE SANS PERTE D'UN SIGNAL SOURCE, A L'AIDE D'UN FLUX DE DONNEES CODEES AVEC PERTE ET D'UN FLUX DE DONNEES D'EXTENSION SANS PERTE

(30) Priority: 05.05.2006 EP 06113596
(43) Date of publication of application: 21.01.2009
(60) Divisional application: 12154030.6
(73) Proprietor: Thomson Licensing, 92130 Issy-les-Moulineaux (FR)
(72) Inventor: JAX, Peter, 30171 Hannover (DE); KEILER, Florian, 30161 Hannover (DE); WÜBBOLT, Oliver, 30161 Hannover (DE); KORDON, Sven, 30173 Hannover (DE); BÖHM, Johannes, 37081 Göttingen (DE)
(74) Representative: Hartnack, Wolfgang
(86) International application number: PCT/EP2007/053784
(87) International publication number: WO 2007/128662

(56) References cited:
- WO-A-00/79520
- WO-A-03/088212
- US-A1- 2003 171 919
- US-B1- 6 498 811
- KEVIN ADISTAMBHA: "Embedded Lossless Audio Coding using Linear Prediction and Cascade coding" THESIS. UNIVERSITY OF WOLLONGONG, 2005, pages 1-89, XP002447409
- RITZ C H ET AL: "Lossless Wideband Speech Coding" PROCEEDINGS OF THE AUSTRALIAN INTERNATIONAL CONFERENCE ON SPEECH SCIENCE AND TECHNOLOGY, XX, XX, 8 December 2004 (2004-12-08), pages 249-252, XP002389966
- JIN A ET AL: "Scalable audio coder based on quantizer units of MDCT coefficients" IEEE INTERNATIONAL CONFERENCE ON ACOUSTICS, SPEECH, AND SIGNAL PROCESSING. PROCEEDINGS., vol. 2, 15 March 1999 (1999-03-15), pages 897-900, XP010328465 PHOENIX, AZ, US ISBN: 0-7803-5041-3

## Description

The invention relates to a method and to an apparatus for lossless encoding of a source signal, using a lossy encoded data stream and a lossless extension data stream which together form a lossless encoded data stream for said source signal.

### Background

In contrast to lossy audio coding techniques (like mp3, AAC etc.), lossless compression algorithms can only exploit redundancies of the original audio signal to reduce the data rate. It is not possible to rely on irrelevancies, as identified by psycho-acoustical models in state-of-the-art lossy audio codecs. Accordingly, the common technical principle of all lossless audio coding schemes is to apply a filter or transform for de-correlation (e.g. a prediction filter or a frequency transform), and then to encode the transformed signal in a lossless manner. The encoded bit stream comprises the parameters of the transform or filter, and the lossless representation of the transformed signal.

See, for example, J. Makhoul, "Linear prediction: A tutorial review", Proceedings of the IEEE, Vol.63, pp.561-580, 1975, T. Painter, A. Spanias, "Perceptual coding of digital audio", Proceedings of the IEEE, vol.88, No.4, pp.451-513, 2000, and M. Hans, R.W. Schafer, "Lossless compression of digital audio", IEEE Signal Processing Magazine, July 2001, pp.21-32.

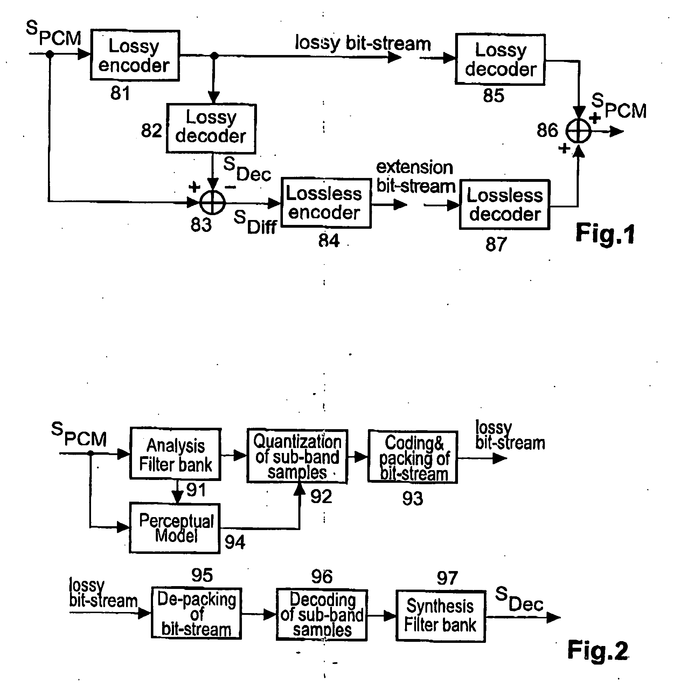

The basic principle of lossy based lossless coding is depicted in Fig. 1 and Fig. 2. In the encoding part on the left side of Fig. 1, a PCM audio input signal SPCM passes through a lossy encoder 81 to a lossy decoder 82 and as a lossy bit stream to a lossy decoder 85 of the decoding part (right side). Lossy encoding and decoding is used to de-correlate the signal. The output signal of decoder 82 is removed from the input signal SPCM in a subtractor 83, and the resulting difference signal passes through a lossless encoder 84 as an extension bit! stream to a lossless decoder 87. The output signals of decoders 85 and 87 are combined 86 so as to regain the original signal SPCM.

This basic principle is disclosed for audio coding in EP-B-0756386 and US-B-6498811, and is also discussed in P. Craven, M. Gerzon, "Lossless Coding for Audio Discs", J. Audio Eng. Soc., Vol.44, No.9, September 1996, and in J. Koller, Th. Sporer, K.H. Brandenburg, "Robust Coding of High Quality Audio Signals", AES 103rd Convention, Preprint 4621, August 1997.

In the lossy encoder in Fig. 2, the PCM audio input signal SPCM passes through an analysis filter bank 91 and a quantisation 92 of sub-band samples to a coding and bit stream packing 93. The quantisation is controlled by a perceptual model calculator 94 that receives signal SPCM and corresponding information from the analysis filter bank 91.

At decoder side, the encoded lossy bit stream enters a means 95 for de-packing the bit stream, followed by means 96 for decoding the subband samples and by a synthesis filter bank 97 that outputs the decoded lossy PCM signal SDec.

Examples for lossy encoding and decoding are described in detail in the standard ISO/IEC 11172-3 (MPEG-1 Audio).

In the state of the art, lossless audio coding is pursued based on one of the following three basic signal processing concepts:
a) time domain de-correlation using linear prediction techniques;
b) frequency domain lossless coding using reversible integer analysis-synthesis filter banks;
c) lossless coding of the residual (error signal) of a lossy base layer codec.

In Kevin Adistambha, "Embedded Lossless Audio Coding using Linear Prediction and Cascade coding", Thesis, University of Wollongong, 2005, pages 1-89, lossless audio coding is described in which the lossless layer residual to be coded is decorrelated by backward linear prediction where the coefficients are obtained from the previously decoded frame.

### Invention

A problem to be solved by the invention is to provide hierarchical lossless audio encoding and decoding, which is build on top of an embedded lossy audio codec and which provides a better efficiency (i.e. compression ratio) as compared to state-of-the-art lossy based lossless audio coding schemes. This problem is solved by the methods disclosed in claims 1, 2, 5 and 6. Apparatuses that utilise these methods are disclosed in claims 3, 4, 7 and 8, respectively.

This invention uses a mathematically lossless encoding and decoding on top of a lossy coding. Mathematically lossless audio compression means audio coding with bit-exact reproduction of the original PCM samples at decoder output. For some embodiments it is assumed that the lossy encoding operates in a transform domain, using e.g. frequency transforms like MDCT or similar filter banks. As an example, the mp3 standard (ISO/IEC 11172-3 Layer 3) will be used for the lossy base layer throughout this description, but the invention can be applied together with other lossy coding schemes (e.g. AAC, MPEG-4 Audio) in a similar manner.

The transmitted or recorded encoded bit stream comprises two parts: the embedded bit stream of the lossy audio codec, and extension data for one or several additional layers to obtain either the lossless (i.e. bit-exact) original PCM samples or intermediate qualities.

The invention basically follows version c) of the above-listed concepts. However, the inventive embodiments utilise features from concepts a) and b) as well, i.e. a synergistic combination of techniques from several ones of the state-of-the-art lossless audio coding schemes.

The invention uses frequency domain de-correlation to prepare the residual signal (error signal) of the base-layer lossy audio codec for efficient lossless encoding. The proposed decorrelation techniques make use of side information that is extracted from the lossy decoder. Thereby, transmission of redundant information in the bit stream is prevented, and the overall compression ratio is improved.

Besides the improved compression ratio, some embodiments of the invention provide the audio signal in one or several intermediate qualities (in the range limited by the lossy codec and mathematically lossless quality). Furthermore, the invention allows for stripping of the embedded lossy bit stream using a simple bit dropping technique.

Two basic embodiments of the invention differ in the domain, in which the de-correlation of the residual signal of the lossy base layer codec takes place: in frequency domain, or in both time and frequency domains in a coordinated manner. In contrast to the prior art, all embodiments utilise information taken from the decoder of the lossy base-layer codec to control the de-correlation and lossless coding process. Some of the embodiments additionally use information from the encoder of the lossy base-layer codec. The exploitation of side information from the lossy base-layer codec allows for reduction of redundancies in the gross bit stream, thus improving the coding efficiency of the lossy based lossless codec.

In all embodiments at least two different variants of the audio signal with different quality levels can be extracted from the bit stream. These variants include the signal represented by the embedded lossy coding scheme and the lossless decoding of the original PCM samples. In some embodiments (see section *Decorrelation in frequency and time domain*) it is possible to decode one or several further variants of the audio signal with intermediate qualities.

In principle, the inventive encoding method is suited for lossless encoding of a source signal, using a lossy encoded data stream and a lossless extension data stream which together form a lossless encoded data stream for said source signal, said method including the steps:
- lossy encoding said source signal, wherein said lossy encoding provides said lossy encoded data stream;
- calculating spectral whitening data from quantised coefficients of said lossy encoded data stream and corresponding not yet quantised coefficients received from said lossy encoding, said spectral whitening data representing a finer quantisation of the original coefficients, whereby said calculating is controlled such that the power of the quantised error is targeted to be constant for all frequencies;
- lossy decoding said lossy encoded data using said spectral whitening data, thereby reconstructing a decoded signal;
- forming a difference signal between a correspondingly delayed version of said source signal and said decoded signal;
- lossless encoding said difference signal to provide said lossless extension data stream;
- combining said lossless extension data stream with said lossy encoded data stream and said spectral whitening data to form said lossless encoded data stream.

In principle, the inventive decoding method is suited for decoding a lossless encoded source signal data stream, which data stream was derived from a lossy encoded data stream and a lossless extension data stream which together form a lossless encoded data stream for said source signal, wherein:
said source signal was lossy encoded, said lossy encoding providing said lossy encoded data stream;
spectral whitening data were calculated from quantised coefficients of said lossy encoded data stream and corresponding not yet quantised coefficients received from said lossy encoding, said spectral whitening data representing a finer quantisation of the original coefficients, whereby said calculating was controlled such that the power of the quantised error is targeted to be constant for all frequencies;
said lossy encoded data were lossy decoded using said spectral whitening data, whereby a decoded signal was reconstructed;
a difference signal was formed between a correspondingly delayed version of said source signal and said decoded signal;
said difference signal was lossless encoded to provide said lossless extension data stream;
said lossless extension data stream was combined with said lossy encoded data stream and said spectral whitening data to form said lossless encoded data stream,
said method including the steps:
   - de-multiplexing said lossless encoded source signal data stream to provide said lossless extension data stream and said spectral whitening data
said lossy encoded data stream and said spectral whitening data,
   - lossy decoding said lossy encoded data stream, using said spectral whitening data, thereby reconstructing a lossy decoded signal;
   - decoding said lossless extension data stream so as to provide said difference signal;
   - combining said difference signal with said lossy decoded signal to reconstruct said source signal.

The inventive apparatuses carry out the functions of the corresponding inventive methods.

Advantageous additional embodiments of the invention are disclosed in the respective dependent claims.

### Drawings

Exemplary embodiments of the invention are described with reference to the accompanying drawings, which show in:
- Fig. 1: basic block diagram for a known lossy based lossless encoder and decoder;
- Fig. 2: general block diagram for a known lossy encoder and decoder;
- Fig. 3: block diagram or signal flow of lossy based lossless encoder with de-corralation of the residual signal in frequency domain;
- Fig. 4: block diagram or signal flow of lossy based lossless decoder with de-correlation of the residual signal in frequency domain;
- Fig. 5: block diagram for a known ISO/IEC 11172-3 Layer III encoder;
- Fig. 6: block diagram or signal flow of lossy based lossless encoder with de-correlation of the residual signal in frequency and time domain;
- Fig.: 7 block diagram or signal flow of lossy based lossless decoder with de-correlation of the residual signal.

### Exemplary embodiments

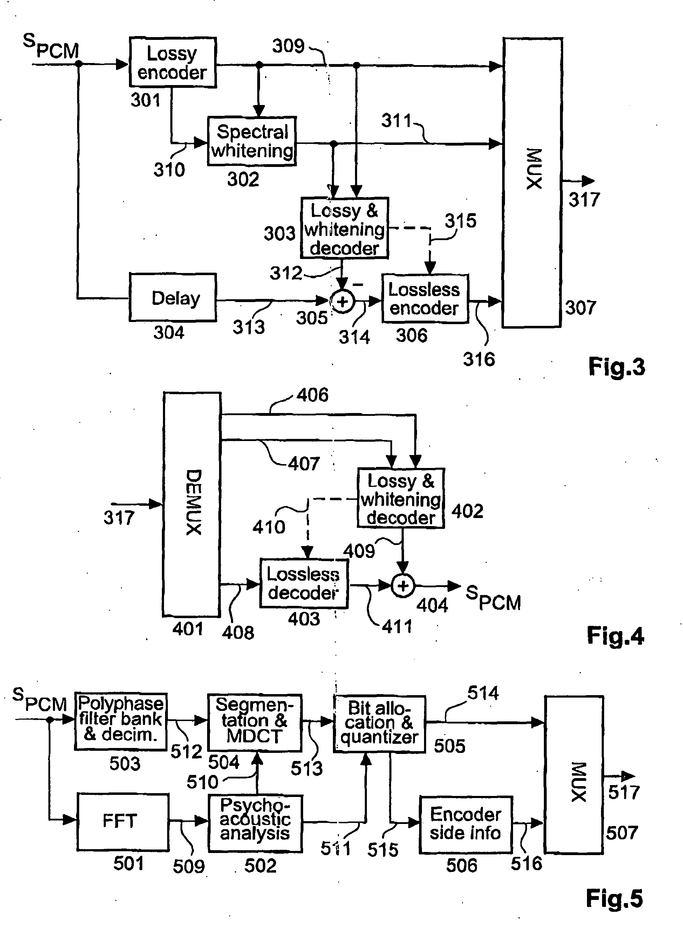

In the encoding depicted in Fig. 3, a lossy encoder 301 uses some transform of the original signal S_{PCM} (or a sub-band signal thereof) before quantising the transform coefficients using adaptive or fixed bit allocation. Without loss of generality, it is assumed in the following that the lossy encoder is based on a frequency transform. After the lossy encoder 301 has produced an embedded backwards-compatible lossy signal part 309 of the combined bit stream 317, a 'spectral whitening' block 302 is applied the purpose of which is to determine the error signal of lossy coder 301 in the transform domain, and to perform additional quantisation of these error coefficients in order to achieve a spectrally flat (i.e. 'white') error floor for the magnitudes of consecutive values of an extension data signal to be encoded. Lossy audio codecs in general apply sophisticated noise shaping techniques to obtain an error spectrum that adheres to the non-white masking threshold of the human ear. The spectral whitening block requires at least the original transform coefficients 310 and the quantised transform coefficients 309 contained in the bit stream as input signals. Such whithening can be achieved by quantising the error within the frequency domain. The difference signal between the original transform coefficients 310 and the quantised transform coefficients 309 in the frequency domain is a mirror or image of the difference signal 314 in the time domain.

The output bit stream 309 of the lossy encoder and the additional information 311 from the spectral whitening block 302 are fed into an extended lossy and whitening decoder block 303 and to a multiplexer 307. The resulting time domain signal 312 is subtracted 305 from the properly delayed version 313 (compensating any delay of the lossy codec) of the original signal S_{PCM}, producing a residual signal 314. Owing to the spectral whitening process, this residual signal has a flat spectrum, i.e. there is negligible correlation between successive samples. The residual signal can be directly fed into a lossless encoder 306 which outputs a lossless extension stream 316. Optionally, side information (see the examples given above; in particular advantageous is the average power of the error signal) 315 from the lossy & whitening decoder 303 can be utilised to control the lossless encoder 306.

To be operational, the lossy & whitening decoder 303, subtractor 305 and any interpolation functionalities that may optionally be implemented inside the lossy decoder block, are implemented in a platform-independent manner. That is, for all targeted platforms a fixed-point implementation with integer precision is required that produces bit-exactly reproducible results.

Multiplexer 307 combines the partial bit streams 309, 311 and 316 to form output bit stream signal 317, and may produce different file formats or bit stream formats.

In the decoding shown in Fig. 4, the received bit stream 317 is de-multiplexed 401 and split into the individual signal layers 406, 407 and 408. Both the embedded lossy bit stream 406 and the spectral whitening bit stream 407 are fed into a lossy and whitening decoder 402. The resulting time domain signal 409 is a bit-exact replica of the intermediate-quality signal 312 in the encoding. A lossless decoder 403 gets inputs from bit stream 408 and optionally from the lossy and whitening decoder (side information 410) to produce the residual signal 411. The final output signal S_{PCM} is obtained by adding the intermediate-quality signal 409 to the lossless decoded residual signal 411.

The operations of elements 402, 403 and 404 are identical to that of the respective elements 303, 306 and 305.

### Optional embodiments

There are several possibilities to control the power of the residual signal by allocating a larger or smaller amount of bits for the spectral whitening. One option is to target a constant power of the residual signal, by a varying amount of quantisation in the spectral whitening block 302, and allowing for a fixed setup of the time domain lossless coding 306. Another option is to allow a variable power level of the time domain residual signal.

By exploiting the parts of the bit stream that are produced by the lossy encoder 301 and by the spectral whitening block 302, a tailored decoder may produce an output signal with an intermediate quality that is between the quality of the embedded lossy codec and the mathematically lossless decoding of the original PCM samples. This intermediate quality depends on the power of the residual signal, controlled in one of the manners described in the previous paragraph. Such decoder may not include the lossless decoder 403 and adder 404 and would not process bitstream 316/408.

To support the generation of more than one intermediate-quality signal, a layered organisation of the spectral whitening information 311 is possible. By this, a codec can be specified which has an arbitrary number of intermediate quality levels in the range defined by the lossy codec (lowest quality) and the original PCM samples (highest quality). The different quality levels can be organised such as to provide a scalable bit stream.

### An example implementation

An example embodiment of the invention is based on the mp3 standard. A block diagram of an mp3 compliant encoder is shown in Fig. 5. In the context of Fig. 3, the mp3 encoder of Fig. 5 (possibly except MUX 507, depending on the bit stream or file format) is part of the lossy encoder block 301.

The original input signal S_{PCM} passes through a polyphase filter bank & decimator 503, a segmentation & MDCT 504 and a bit allocation and quantiser 505 to multiplexer 507. Input signal S_{PCM} also passes through an FFT stage or step 501 to a psycho-acoustic analysis 502 which controls the segmentation (or windowing) in step/stage 504 and the quantisation 505. The bit allocation and quantiser 505 also provides side information 515 that passes through a side info encoder 506 to multiplexer 507 which outputs signal 517.

Let x denote an individual but arbitrary original transform coefficient from the output vector 513 of block 504, i.e. in the MDCT domain for mp3, and let x̂ denote the quantised version of the same coefficient, represented and encoded by the bit stream 514, which is part of output signal 517 or 309, respectively. In addition to the bit stream 309/517, the original vector of MDCT coefficients 513 is passed on to the spectral whitening block 302. Accordingly, signal 310 comprises signal 513 and optionally additional useful side information from the mp3 encoder. In the spectral whitening block 302, the error *e*=*x-*x̂ of the mp3 codec is quantised by a second quantiser with the aim to obtain a white error floor, i.e. a spectrally flat (white) error spectrum *e-ê*, *ê=Q*(*e*)*.* Thus, the bit allocation to be applied in the spectral whitening block shall be controlled such that the condition E{(*e-ê*)²} = constant is met, wherein E is the expectation value.

For the spectral whitening quantiser known quantisation techniques can be used, e.g. scalar or lattice quantisation followed by entropy coding, or optimised (trained) fixed-entropy scalar or vector quantisation. The best results are expected if the spectral whitening quantiser is selected and optimised in dependence on the parameter values of the original mp3 quantiser of the spectral coefficient. That is, the spectral whitening quantiser should be a conditional quantiser.

### De-correlation in frequency and time domains

This embodiment combines features described in the sections *time domain de-correlation* and *frequency domain de-correlation.* The de-correlation is split into two sub-systems, operating in frequency domain and in time domain, respectively.

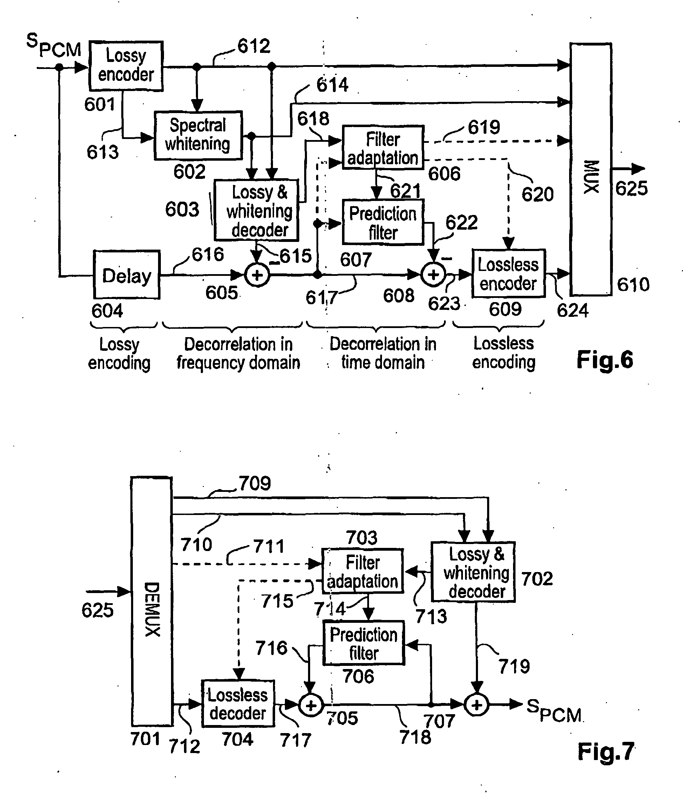

In the encoding depicted in Fig. 6, a lossy encoder 601 uses some transform of the original signal S_{PCM} (or a sub-band signal thereof) before quantising the transform coefficients with adaptive or fixed bit allocation. Without loss of generality, it is assumed in the following that encoder 601 uses a frequency transform. After having produced an embedded backwards-compatible lossy signal part 612 of the combined bit stream 625, a spectral whitening block 602 is applied the purpose of which is to determine the error signal of encoder 601 in the transform domain, and to perform additional quantisation of these error coefficients in order to achieve for consecutive values of the extension data signal to be encoded an error floor that is spectrally more flat or white than that of the input error spectrum of the lossy decoder. The spectral whitening block requires at least the original transform coefficients 613 and the quantised transform coefficients 612 as input signals.

The output bit stream 612 of the lossy encoder and the corresponding additional information 614 from the spectral whitening block 602 are fed to a lossy and whitening decoder block 603 and to a multiplexer 610. Its resulting time domain output signal 615 is subtracted 605 from the properly delayed version 616 of the original signal S_{PCM}, producing a residual signal 617.

The still remaining weak correlation between successive samples of the residual signal 617 is removed in a linear prediction filter 607. The side information (see the examples given above, e.g. the envelope of the error spectrum) 618 that is extracted from the lossy and whitening decoder block 603 is used in a filter adaptation block 606 to determine a set 621 of optimum filter coefficients to be applied in filter 607. The aim of the prediction filtering and the subtraction 608 is to produce a completely de-correlated output signal 623 with a flat or white spectrum. This residual signal passes through a lossless encoder 609 which outputs a lossless extension stream 624. Optionally, side information (see the examples given above, e.g. the signal power) 620 from filter adaptation block 606 can be utilised to control encoder 609. Information from block 606 about the prediction filter settings is optionally sent to multiplexer 610. The corresponding information stream 619 is always lower in data rate than for systems without exploitation of side information 618.

Multiplexer 610 combines the partial bit streams 612, 614, 619 and 624 to form output signal 625, and may produce different file formats or bit stream formats.

In the decoding depicted in Fig. 7, the received bit stream 625 is split by a demultiplexer 701 into the individual signal layers 709, 710, 711 and 712. Both, the embedded lossy bit stream 709 and the spectral whitening bit stream 710, are fed to a lossy and whitening decoder 702. Its lossy or intermediate-quality time domain output signal 719 is a bit-exact replica of the lossy or intermediate-quality signal 615 in the encoding.

Decoder 702 also provides side information 713 to a filter adaptation block 703. From this side information and any optional bit stream components 711 (corresponding to signal 619 in Fig. 6), a filter adaptation is performed exactly like in the corresponding encoding block 606.

A lossless decoder 704 gets inputs from lossless extension bit stream 712 and optionally from side information 715 (corresponding to side information 620 in Fig. 6) output by filter adaptation block 703, to produce the (partially) decorrelated residual signal 717 (corresponds to signal 623 in Fig. 6). That signal is fed to an inverse de-correlation filter comprising an adder 705 and a prediction filter 706 that is controlled by the filter coefficients 714 provided by block 703, thus producing a bit-exact replica 718 of the residual signal 617. The final output signal S_{PCM} is obtained by combining in adder 707 the lossy decoded signal 719 and the lossless decoded residual signal 718. Filter coefficients 714 are identical to filter coefficients 621.

The operations of elements 702, 704, 705, 706 and 707 are identical to that of the respective elements 603, 609, 608, 607 and 605.

One strategy to control the balance between frequency and time domain de-correlation is to constrain the summed data rate of the lossy part and spectral whitening part of the bit stream. If there is a fixed upper limit to the data rate of these two components of the bit stream, the spectral whitening can only perform a certain portion of the task of de-correlation of the error signal. That is, the time domain residual signal 617 will still exhibit a certain amount of correlation. This remaining correlation is removed by the downstream time domain de-correlation using linear prediction filtering, exploiting information taken from the lossy & whitening decoder

Another strategy is to use frequency domain de-correlation only to remove long-term correlation from the residual signal, i.e. correlation characteristics of the signal which are narrow (or 'peaky') in frequency domain, corresponding to tonal components of the residual signal. Subsequently, the time domain de-correlation by linear prediction filtering is optimised and used to remove the remaining short-term correlation from the residual signal. Advantageously, thereby both de-correlation techniques are used in their specifically best operation points. Hence, this kind of processing allows very efficient encoding with low computational complexity.

### Optional embodiments

There are several possibilities to control the power of the residual signal by allocating a larger or smaller amount of bits for the spectral whitening. One option is to target a constant power of the residual signal, by a varying amount of quantisation in the spectral whitening block 602, and allowing for a fixed setup of the time domain lossless coding 609. Another option is to allow a variable power level of the time domain residual signal.

By exploiting the parts of the bit stream that are produced by the lossy encoder 601 and by the spectral whitening block 602, a tailored decoder may produce an output signal with an intermediate quality that is between the quality of the embedded lossy codec and the mathematically lossless decoding of the original PCM samples. This intermediate quality depends on the power of the residual signal, controlled in one of the manners described in the previous paragraph. Such decoder may not include the lossless decoder 704, filter adaptation block 703, prediction filter 706 and adders 705 and 707.

## Claims

1. Method for lossless encoding of a source signal (S_{PCM}), using a lossy encoded data stream (309, 612) and a lossless extension data stream (316, 624) which together form a lossless encoded data stream (317, 625) for said source signal, said method including the steps:
- lossy encoding (301, 601) said source signal, wherein said lossy encoding provides said lossy encoded data stream (309, 612),
**characterised by**:
- calculating (302, 602) spectral whitening data (311, 614) from quantised coefficients of said lossy encoded data stream and corresponding hot yet quantised coefficients received from said lossy encoding, said spectral whitening data representing a finer quantisation of the original coefficients, whereby said calculating is controlled such that the power of the quantised error is targeted to be constant for all frequencies;
- lossy decoding (303, 603) said lossy encoded data using said spectral whitening data, thereby reconstructing a decoded signal (312, 615);
- forming (305, 605) a difference signal (314, 617) between a correspondingly delayed (304, 604) version of said source signal (S_{PCM}) and said decoded signal (312, 615);
- lossless encoding (306, 609) said difference signal to provide said lossless extension data stream (316, 624);
- combining (307, 610) said lossless extension data stream with said lossy encoded data stream and said spectral whitening data (311, 614) to form said lossless encoded data stream (317, 625).

2. Method according to claim 1, including the further steps:
- in said lossy decoding (603) of said lossy encoded data using said spectral whitening data, providing side information (618) for controlling a time domain prediction filter;
- prediction filtering (607, 608) said difference signal (617) using filter coefficients (621) that are derived (606) from said side information so as to de-correlate in the time domain the consecutive values of said difference signal (617);
- when lossless encoding, encoding (609) said de-correlated difference signal (623) instead of said difference signal (314, 617).

3. Apparatus for lossless encoding of a source signal (S_{PCM}), using a lossy encoded data stream (309, 612) and a lossless extension data stream (316, 624) which together form a lossless encoded data stream (317, 625) for said source signal, said apparatus including:
- means (301, 601) being adapted for lossy encoding said source signal, wherein said lossy encoding provides said lossy encoded data stream (309, 612),
**characterised by**:
- means (302, 602) being adapted for calculating spectral whitening data (311, 614) from quantised coefficients of said lossy encoded data stream and corresponding not yet quantised coefficients received from said lossy encoding, said spectral whitening data representing a finer quantisation of the original coefficients, whereby said calculating is controlled such that the power of the quantised error is targeted to be constant for all frequencies;
- means (303, 603) being adapted for lossy decoding said lossy encoded data using said spectral whitening data, thereby reconstructing a decoded signal (312, 615);
- means (305, 304, 605, 604) being adapted for forming a difference signal (314, 617) between a correspondingly delayed version of said source signal (S_{PCM}) and said decoded signal (312, 615);
- means (306, 609) being adapted for lossless encoding said difference signal to provide said lossless extension data stream (316, 624);
- means (307, 610) being adapted for combining said lossless extension data stream with said lossy encoded data stream and said spectral whitening data (311, 614) to form said lossless encoded data stream (317, 625).

4. Apparatus according to claim 3, wherein:
- in said lossy decoding means (603), side information (618) is provided for controlling a time domain prediction filter;
- means (607, 608) for prediction filtering filter said difference signal (617) using filter coefficients (621) that are derived (606) from said side information so as to de-correlate in the time domain the consecutive values of said difference signal (617);
- in said lossless encoding means, said de-correlated difference signal (623) is encoded (609) instead of said difference signal (314, 617).

5. Method for decoding a lossless encoded source signal (S_{PCM}) data stream, which data stream was derived from a lossy encoded data stream (309, 612) and a lossless extension data stream (316, 624) which together form a lossless encoded data stream (317, 625) for said source signal, wherein:
said source signal was lossy encoded (301, 601), said lossy encoding providing said lossy encoded data stream (309, 612);
spectral whitening data (311, 614) were calculated (302, 602) from quantised coefficients of said lossy encoded data stream and corresponding not yet quantised coefficients were received from said lossy encoding, said spectral whitening data representing a finer quantisation of the original coefficients, whereby said calculating was controlled such that the power of the quantised error is targeted to be constant for all frequencies;
said lossy encoded data were lossy decoded (303, 603) using said spectral whitening data, whereby a decoded signal (312, 615) was reconstructed;
a difference signal (314, 617) was formed (305, 605) between a correspondingly delayed (304, 604) version of said source signal (S_{PCM}) and said decoded signal (312, 615);
said difference signal was lossless encoded (306, 609) to provide said lossless extension data stream (316, 624);
said lossless extension data stream was combined (307, 610) with said lossy encoded data stream and said spectral whitening data (311, 614) to form said lossless encoded data stream (317, 625),
said method including the steps:
- de-multiplexing (401, 701) said lossless encoded source signal data stream (317, 625) to provide said lossless extension data stream (408, 712), said lossy encoded data stream (406, 709) and said spectral whitening data (407,710)
- lossy decoding (402, 702) said lossy encoded data stream, using said spectral whitening data (407, 710), thereby reconstructing a lossy decoded signal (409, 719);
- decoding (403, 704) said lossless extension data stream so as to provide said difference signal (411, 717);
- combining (404, 707) said difference signal (411, 717) with said lossy decoded signal (409, 719) to reconstruct said source signal (S_{PCM}).

6. Method according to claim 5, wherein at encoder side:
in said lossy decoding (603) of said lossy encoded data using said spectral whitening data, side information (618) for controlling a time domain prediction filter was provided;
said difference signal was prediction filtered (607, 608) using filter coefficients (621) that were derived (606) from said side information so as to de-correlate in the time domain the consecutive values of said difference signal;
- when lossless encoding, said de-correlated difference signal (623) was encoded (609) instead of said difference signal (314, 617),
said method including at decoder side the further steps:
- in said lossy decoding (702), providing side information (713) for controlling a time domain prediction filter (705, 706);
- inversely de-correlation filtering (705, 706) consecutive values of said de-correlated difference signal using filter coefficients (714) that are derived (703) from said side information (713);
- instead of said difference signal (411), combining (707) said de-correlation filtered difference signal (718) with said lossy decoded signal (719) to reconstruct said source signal (S_{PCM}).

7. Apparatus for decoding a lossless encoded source signal (S_{PCM}) data stream, which data stream was derived from a lossy encoded data stream (309, 612) and a lossless extension data stream (316, 624) which together form a lossless encoded data stream (317, 625) for said source signal, wherein:
said source signal was lossy encoded (301, 601), said lossy encoding providing said lossy encoded data stream (309, 612);
spectral whitening data (311, 614) were calculated (302, 602) from quantised coefficients of said lossy encoded data stream and corresponding not yet quantised coefficients received from said lossy encoding, said spectral whitening data representing a finer quantisation of the original coefficients, whereby said calculating was controlled such that the power of the quantised error is targeted to be constant for all frequencies;
said lossy encoded data were lossy decoded (303, 603) using said spectral whitening data, whereby a decoded signal (312, 615) was reconstructed;
a difference signal (314, 617) was formed (305, 605) between a correspondingly delayed (304, 604) version of said source signal (S_{PCM}) and said decoded signal (312, 615);
said difference signal was lossless encoded (306, 609) to provide said lossless extension data stream (316, 624);
said lossless extension data stream was combined (307, 610) with said lossy encoded data stream and said spectral whitening data (311, 614) to form said lossless encoded data stream (317, 625),
said apparatus including:
- means (401, 701) being adapted for de-multiplexing said lossless encoded source signal data stream (317, 625) to provide said lossless extension data stream (408, 712) said lossy encoded data stream (406, 709) and said spectral whitening data (407, 710);
- means (402, 702) being adapted for lossy decoding said lossy encoded data stream, using said spectral whitening data (407, 710), thereby reconstructing a lossy decoded signal (409, 719);
- means (403, 704) being adopted for decoding said lossless extension data stream so as to provide said difference signal (411, 717);
- means (404, 704) being adapted for combining said difference signal (411, 717) with said lossy decoded signal (409, 719) to reconstruct said source signal (S_{PCM}).

8. Apparatus according to claim 7, wherein at encoder side:
in said lossy decoding (603) of said lossy encoded data using said spectral whitening data, side information (618) for controlling a time domain prediction filter was provided;
said difference signal was prediction filtered (607, 608) using filter coefficients (621) that were derived (606) from said side information so as to de-correlate in the time domain the consecutive values of said difference signal;
when lossless encoding, said de-correlated difference
signal (623) was encoded (609) instead of said difference signal (319, 617),
said apparatus including:
- in said lossy decoding means (702) side information (713) is provided for controlling a time domain prediction filter (705, 706) ;
- means (705, 706) being adapted for inversely de-correlation filtering consecutive values of said de-correlated difference signal using filter coefficients (714) that are derived (703) from said side information (713);
- instead of said difference signal (411), combining in said combining means (707) said de-correlation filtered difference signal (718) with said lossy decoded signal (719) to reconstruct said source signal (S_{PCM}).

9. Method according to claim 2 or 6, or apparatus according to claim 4 or 8, wherein from said side information (618) prediction filter settings data (619) are derived and included in said lossless encoded data stream (625), or side information prediction filter settings data (711) are taken from said lossless encoded data stream (625) and are used for generating (703) said prediction filtering coefficients (714), respectively.

10. Method according to the method of one of claims 2, 6 and 9, or apparatus according to the apparatus of one of claims 4, 8 and 9, wherein the standard deviation (620, 715) of the prediction residual is used to parameterise said lossless encoding (609), or to control said lossless decoding (704), respectively.

11. Method according to claim 1 or 5, or apparatus according to claim 3 or 7, wherein side information (315, 410) from said lossy decoder 303, 402) is used to control said lossless encoding (306), or said lossless decoding (403), respectively.

12. Method according to claim 5 or 6, or apparatus according to claim 7 or 8, wherein said lossless extension data stream (408, 712) is not evaluated and said spectral whitening data (407, 710) are used together with said lossy encoded data stream (406, 709) to decode (402, 702) an output signal having an intermediate quality lower than that of said source signal.

13. Storage medium, for example on optical disc, that contains or stores, or has recorded on it, a digital signal encoded according to the method of one of claims 1, 2 and 9 to 11.

## Patentansprüche

1. Verfahren zum verlustlosen Kodieren eines Quellensignals (S_{PCM}) unter Verwendung eines verlustbehaftet kodierten Datenstroms (309,612) und eines verlustlosen Erweiterungsdatenstroms (316,624), die zusammen einen verlustlos kodierten Datenstrom (317,625) für das Quellensignal bilden, wobei das Verfahren die Schritte einschließt:
- Verlustbehaftetes Kodieren (301,601) des Quellensignals, wobei das verlustbehaftete Kodieren den verlustbehaftet kodierten Datenstrom (309,612) liefert, **gekennzeichnet durch**:
Berechnen (302,602) spektraler weißmachender Daten (311, 614) aus quantisierten Koeffizienten des verlustbehaftet kodierten Datenstroms und entsprechenden noch nicht quantisierten, aus der verlustbehafteten Kodierung empfangenen Koeffizienten, wobei die spektralen weißmachenden Daten eine feinere Quantisierung der ursprünglichen Koeffizienten darstellen, und wobei die Berechnung so gesteuert wird, dass als Ziel die Leistung des quantisierten Fehlers für alle Frequenzen konstant ist;
- verlustbehaftetes Dekodieren (303,603) der verlustbehaftet kodierten Daten unter Verwendung der spektralen weißmachenden Daten, um **dadurch** ein dekodiertes Signal (312,615) zu rekonstruieren;
- Bilden (305,605) eines Differenzsignals (314,617) zwischen einer entsprechend verzögerten (304,604) Version des Quellensignals (S_{PCM}) und dem dekodierten Signal (312, 615);
- Verlustloses Kodieren (306, 309) des Differenzsignals, um den verlustlosen Erweiterungsdatenstrom (316,624) bereitzustellen;
- Kombinieren (307,610)des verlustlosen Erweiterungsdatenstroms mit dem verlustbehaftet kodierten Datenstrom und den spektralen weißmachenden Daten (311,614), um den verlustlos kodierten Datenstrom zu (317,625) bilden.

2. Verfahren nach Anspruch 1, das die weiteren Schritte einschliesst;
- Bereitstellen von Seiteninformationen (618) bei dem verlustbehafteten Dekodieren (603) der verlustbehaftet kodierten Daten unter Verwendung der spektralen weißmachenden Daten zur Steuerung eines Zeitbereichs-Vorhersagefilters;
- Vorhersagefilterung (607, 608) des Differenzsignals (617) unter Verwendung von Filterkoeffizienten (621), die von den Seiteninformationen abgeleitet werden (606), um so in dem Zeitbereich die aufeinanderfolgenden Werte des Differenzsignals zu entkorrelieren (617);
- wenn verlustlos kodiert wird, Kodieren (609) des entkorrelierten Differenzsignals (623) anstelle des Differenzsignals (314, 617).

3. Vorrichtung zum verlustlosen Kodieren eines Quellensignals (S_{PCM}) unter Verwendung eines verlustbehaftet kodierten Datenstroms (309, 612) und eines verlustlosen Erweiterungsdatenstroms (316, 624), die zusammen einen verlustlos kodierten Datenstrom (317,625) für das Quellensignal bilden, wobei die Vorrichtung einschliesst:
- Mittel (301,601) zum verlustbehafteten Kodieren des Quellensignals, wobei das verlustbehaftete Kodieren den verlustbehaftet kodierten Datenstrom (309,612) liefert, **gekennzeichnet durch**:
- Mittel (302,602) zum Berechnen spektraler weißmachender Daten (311,614) aus quantisierten Koeffizienten des verlustbehaftet kodierten Datenstroms und entsprechenden noch nicht quantisierten, aus der verlustbehafteten Kodierung empfangenen Koeffizienten, wobei die spektralen weißmachenden Daten eine feinere Quantisierung der ursprünglichen Koeffizienten, darstellen, und wobei die Berechnung so gesteuert wird, dass als Ziel die Leistung des quantisierten Fehlers für alle Frequenzen konstant ist;
- Mittel (303,609) zum verlustbehafteten Dekodieren der verlustbehaftet kodierten Daten unter Verwendung der spektralen weißmachenden Daten, um **dadurch** ein dekodiertes Signal (312,615) zu rekonstruieren;
- Mittel (305,304,605,604) zum Bilden eines Differenzsignals (314,617) zwischen einer entsprechend verzögerten Version des Quellensignals (S_{PCM}) und dem dekodierten Signal (312,615);
- Mittel (306,609) zum verlustlosen Kodieren des Differenzsignals, um den verlustlosen Erweiterungsdatenstrom (316,624) bereitzustellen;
- Mittel (307,610) zum Kombinieren des verlustlosen Erweiterungsdatenstroms mit dem verlustbehaftet kodierten Datenstrom und den spektralen weißmachenden Daten (311,614), um den verlustlos kodierten Datenstrom (317,625) zu bilden.

4. Vorrichtung nach Anspruch 3, bei der:
- in den verlustbehafteten Dekodiermitteln (603) Seiteninformationen (618) zur Steuerung eines Zeitbereichs-Vorhersagefilters bereitgestellt werden;
- Mittel (607,608) zur Vorhersagefilterung des Differenzsignals (617) unter Verwendung von Filterkoeffizienten (621), die von den Seiteninformationen abgeleitet werden, vorgesehen sind,um so in dem Zeitbereich die aufeinanderfolgenden Werte des Differenzsignals (617)zu entkorrelieren;
- in den verlustlosen Kodiermitteln das entkorrelierte Differenzsignal (623)anstelle des Differenzsignals 314, 617) kodiert (609) wird.

5. Verfahren zum Dekodieren eines verlustlos kodierten Quellensignal-(S_{PCM})-Datenstroms, der von einem verlustbehaftet kodierten Datenstrom (309,612) und einem verlustlosen Erweiterungsdatenstrom (316,624) abgeleitet wurde, die zusammen einen verlustlos kodierten Datenstrom (317,625) für das Quellensignal bilden, bei dem:
- das Quellensignal verlustbehaftet kodiert wurde (301, 601), das verlustbehaftete Kodieren den verlustbehaftet kodierten Datenstrom (309, 612) liefert;
- spektrale weißmachende Daten (311,614) aus quantisierten Koeffizienten des verlustbehaftet kodierten Datenstroms berechnet wurden (302,602) und entsprechende noch nicht quantisierte Koeffizienten aus der verlustbehafteten Kodierung empfangen wurden, wobei die spektralen weißmachenden Daten eine feinere Quantisierung der ursprünglichen Koeffizienten darstellen, wodurch die Berechnung so gesteuert wurde, dass als Ziel die Leistung des quantisierten Fehlers für alle Frequenzen konstant ist;
- die verlustbehaftet kodierten Daten verlustbehaftet unter Verwendung der spektralen weißmachenden Daten dekodiert wurden (303,603), wodurch ein dekodiertes Signal (312,615) rekonstruiert wurde;
- ein Differenzsignal (314,617) zwischen einer entsprechend verzögerten (304,604) Version des Quellensignals (S_{PCM}) und des dekodierten Signals (312,615) gebildet wurde (305,605);
- das Differenzsignal verlustlos kodiert wurde (306,609), um den verlustlosen Erweiterungsdatenstrom zu liefern;
- der verlustlose Erweiterungsdatenstrom mit dem verlustbehaftet kodierten Datenstrom und den spektralen weißmachenden Daten (311,614) kombiniert wurde (307,610), um den verlustlos kodierten Datenstrom (317,625) zu bilden, wobei das Verfahren die Schritte einschliesst:
- Demultiplexen (401,701) des verlustlos kodierten Quellensignaldatenstroms (317,625), um den verlustlosen Erweiterungsdatenstrom (408,712), den verlustbehaftet kodierten Datenstrom (406,709) und die spektralen weißmachenden Daten (407,710) bereitzustellen;
- verlustbehaftetes Dekodieren (402,702) des verlustbehaftet kodierten Datenstroms unter Verwendung der spektralen weißmachenden Daten (407,710), um dadurch ein verlustbehaftet dekodiertes Signal (400,719) zu rekonstruieren;
- Dekodieren (403,704) des verlustlosen Erweiterungsdatenstroms, um so das Differenzsignal (411,717) zu liefern;
- Kombinieren (404,707) des Differenzsignals (411,717) mit dem verlustbehaftet dekodierten Signal (409,719), um das Quellensignal (S_{PCM}) zu rekonstruieren.

6. Verfahren nach Anspruch 5, bei dem auf der Kodiererseite:
Bei der verlustbehafteten Dekodierung (603) der verlustbehaftet kodierten Daten unter Verwendung der spektralen weißmachenden Daten Seiteninformationen (618) zur Steuerung eines Zeitbereichs-Vorhersagefilters bereitgestellt wurden;
das Differenzsignal unter Verwendung von Filterkoeffizienten (621), die von den Seiteninformationen abgeleitet wurden (606), vorhersagegefiltert wurde (607,608), um in dem Zeitbereich die aufeinanderfolgenden Werte des Differenzsignals zu entkorrelieren;
- bei der verlustlosen Kodierung das entkorrelierte Differenzsignal (623) anstelle des Differenzsignals (314,617) kodiert (609) wurde, wobei das Verfahren auf der Dekodiererseite die weiteren Schritte einschließt:
- Bei der verlustlosen Dekodierung (702) Bereitstellen von Seiteninformationen (713) zur Steuerung eines Zeitbereichs-Vorhersagefilters (705,706);
- inverse Entkorrelationsfilterung (705,706) aufeinanderfolgender Werte des entkorrelierten Differenzsignals unter Verwendung von Filterkoeffizienten (714), die aus den Seiteninformationen (713) abgeleitet wurden (703);
- anstelle des Differenzsignals (411), Kombinieren (707) des entkorrelationsgefilterten Differenzsignals (718) mit dem verlustbehaftet dekodierten Signal (719), um das Quellensignal (S_{PCM}) zu rekonstruieren.

7. Vorrichtung zum Dekodieren eines verlustlos kodierten Quellensignal-(S_{PCM})-Datenstroms, der aus einem verlustbehaftet kodierten Datenstrom (309,612) und einem verlustlosen Erweiterungsdatenstrom (316,624) abgeleitet wurde, die zusammen einen verlustlos kodierten Datenstrom (317,625) bilden, wobei:
- Das Quellensignal verlustbehaftet kodiert wurde (301,601) und die verlustbehaftete Kodierung den verlustbehaftet kodierten Datenstrom (309,612) liefert;
- spektrale weißmachende Daten (311,614) aus quantisierten Koeffizienten des verlustbehaftet kodierten Datenstroms und entsprechenden noch nicht quantisierten, aus der verlustbehafteten Kodierung empfangenen Koeffizienten berechnet wurden (302,602), wobei die spektralen weißmachenden Daten eine feinere Quantisierung der ursprünglichen Koeffizienten darstellen, wodurch die Berechnung so gesteuert wurde, dass als Ziel die Leistung des quantisierten Fehlers für'alle Frequenzen konstant ist;
- die verlustbehaftet kodierten Daten verlustbehaftet unter Verwendung der spektralen weißmachenden Daten dekodiert wurden (303,603), wodurch ein dekodiertes Signal (312,615) rekonstruiert wurde;
- ein Differenzsignal (314,617) zwischen einer entsprechend verzögerten (304,604) Version des Quellensignals (S_{PCM}) und des dekodierten Signals (312,615) gebildet wurde (305,605);
- das Differenzsignal verlustlos kodiert wurde (306,609), um den verlustlosen Erweiterungsdatenstrom (316,624) zu liefern;
- der verlustlose Erweiterungsdatenstrom mit dem verlustbehaftet kodierten Datenstrom und den spektralen weißmachenden Daten (311,614) kombiniert (307,610) wurde, um den verlustlos kodierten Datenstroms (317,625) zu bilden, wobei die Vorrichtung einschliesst:
- Mittel (401,701) zum Demultiplexen des verlustlos kodierten Quellensignaldatenstroms (317,625), um den verlustlosen Erweiterungsdatenstrom (408,712), den verlustbehaftet kodierten Datenstrom (406,709) und die spektralen weißmachenden Daten (407,710) bereitzustellen;
- Mittel (402,702) zum verlustbehafteten Dekodieren des veerlustbehaftet kodierten Datenstroms unter Verwendung der spektralen weißmachender Daten (407,710), um dadurch ein verlustbehaftet dekodiertes Signal (409,719) zu rekonstruieren;
- Mittel (403,704) zum Dekodieren des verlustlosen Erweiterungsdatenstroms, um so das Differenzsignal (411,717) zu liefern;
- Mittel (404,704) zum Kombinieren des Differenzsignals (411,717) mit dem verlustbehaftet dekodierten Signal (409,719), um das Quellensignal (S_{PCM}) zu rekonstruieren.

8. Vorrichtung nach Anspruch 7, bei dem auf der Kodiererseite:
Bei der verlustbehafteten Dekodierung (603) der verlustbehaftet kodierten Daten unter Verwendung der spektralen weißmachenden Daten Seiteninformationen (618) zur Steuerung eines Zeitbereichs-Vorhersagefilters bereitgestellt wurden;
das Differenzsignal unter Verwendung von Filterkoeffizienten (621), die von den Seiteninformationen abgeleitet wurden (606), vorhersagegefiltert wurde (607,608), um in dem Zeitbereich die aufeinanderfolgenden Werte des Differenzsignals zu entkorrelieren;
bei der verlustlosen Kodierung das entkorrelierte Differenzsignal (623) anstelle des Differenzsignals (314,617) kodiert wurde, wobei die Vorrichtung einschliesst:
- In den verlustbehafteten Dekodiermitteln (702) vorgesehene Seiteninformationen (713) zur Steuerung eines Zeitbereichs-Vorhersagefilters (705,706);
- Mittel (705,706) zur inversen Entkorrelationsfilterung aufeinanderfolgender Werte des entkorrelierten Differenzsignals unter Verwendung von Filterkoeffizienten (714), die aus den Seiteninformationen (713) abgeleitet werden (703);
- Kombinieren in den Kombinationsmitteln (707) anstelle des Differenzsignals (718) das entkorrelationsgefilterte Differenzsignal (718) mit dem verlustbehaftet dekodierten Signal (719), um das Quellensignal (S_{PCM}) zu rekonstruieren.

9. Verfahren nach Anspruch 2 oder 6 oder Vorrichtung nach Anspruch 4 oder 8, bei dem bzw. bei der aus den Seiteninformationen (618) Vorhersagefilter-Einstellungsdaten (619) abgeleitet und in den verlustlos kodierten Datenstrom (625) eingeschlossen werden bzw. Vorhersagefilter-Einstellungsdaten (711) aus den Seiteninformationen dem verlustlos kodierten Datenstrom (625) entnommen und zur Erzeugung (703) der Vorhersagefilterkoeffizienten (714) verwendet werden.

10. Verfahren nach einem der Ansprüche 2, 6 und 9 oder Vorrichtung nach einem der Ansprüche 4, 8 und 9, bei dem bzw. bei der die Standardabweichung (620,715) des Vorhersagerestes verwendet wird, um die verlustlose Kodierung (609) zu parametrieren bzw. die verlustlose Dekodierung zu steuern.

11. verfahren nach Anspruch 1 oder 5 oder Vorrichtung nach Anspruch 3 oder 7, bei dem bzw. bei der die Seiteninformationen (315,410) aus dem verlustbehafteten Dekodierer verwendet werden, um die verlustlose Kodierung (306) bzw. die verlustlose Dekodierung (403) zu steuern.

12. Verfahren nach Anspruch 5 oder 6 oder Vorrichtung nach Anspruch 7 oder 8, bei dem bzw. bei der verlustlose Erweiterungsdatenstrom (408, 712) nicht bewertet wird und die spektralen weißmachenden Daten (407,710) zusammen mit dem verlustbehaftet kodierten Datenstrom (406,709) verwendet werden, um ein Ausgangssignal zu dekodieren (402,702), das eine mittlere Qualität hat, die kleiner ist als die des Quellensignals.

13. Speichermedium, z.B. eine optische Disk, das ein digitales Signal enthält oder speichert, das gemäss dem Verfahren eines der Ansprüche 1, 2 und 9 bis 11 kodiert ist oder auf dem ein solches Signal aufgezeichnet ist.

## Revendications

1. Procédé pour le codage sans perte d'un signal source (S_{PCM}), à l'aide d'un flux de données codées avec perte (309, 612) et d'un flux de données d'extension sans perte (316, 624) qui forment ensemble un flux de données codées sans perte (317, 625) pour ledit signal source, ledit procédé incluant les étapes suivantes :
- le codage avec perte (301, 601) dudit signal source, où ledit codage avec perte fournit ledit flux de données codées avec perte (309, 612),
**caractérisé par** :
- le calcul (302, 602) de données de blanchiment spectral (311, 614) à partir des coefficients quantifiés dudit flux de données codées avec perte et des coefficients qui ne sont pas encore quantifiés correspondants reçus à partir dudit codage avec perte, lesdites données de blanchiment spectral représentant une quantification plus précise des coefficients d'origine, où ledit calcul est contrôlé de telle sorte que la puissance de l'erreur quantifiée a pour objectif d'être constante pour toutes les fréquences ;
- le décodage avec perte (303, 603) desdites données codées avec perte à l'aide des données de blanchiment spectral, reconstruisant ainsi un signal décodé (312, 615) ;
- la formation (305, 605) d'un signal de différence (314, 617) entre une version retardée proportionnellement (304, 604) dudit signal source (S_{PCM}) et dudit signal décodé (312, 615) ;
- le codage sans perte (306, 609) dudit signal de différence afin de fournir ledit flux de données d'extension sans perte (316, 624) ;
- la combinaison (307, 610) dudit flux de données d'extension sans perte avec ledit flux de données codées avec perte et lesdites données de blanchiment spectral (311, 614) pour former ledit flux de données codées sans perte (317, 625).

2. Procédé selon la revendication 1, comprenant en outre les étapes suivantes :
- dans ledit décodage avec perte (603) desdites données codées avec perte à l'aide descites données de blanchiment spectral, la mise à disposition des informations secondaires (618) afin de contrôler un filtre de prédiction dans le domaine temporel ;
- le filtrage de prédiction (607, 608) dudit signal de différence (617) à l'aide des coefficients de filtre (621) qui sont dérivés (606) desdites informations secondaires de façon à décorréler dans le domaine temporel les valeurs consécutives dudit signal de différence (617) ;
- lorsque le codage sans perte, le codage (609) dudit signal de différence décorrélé (623) à la place dudit signal de différence (314, 617).

3. Appareil pour le codage sans perte d'un signal source (S_{PCM}), à l'aide d'un flux de données codées avec perte (309, 612) et d'un flux de données d'extension sans perte (316, 624) qui forment ensemble un flux de données codées sans perte (317, 625) pour ledit signal source, ledit appareil incluant :
- un moyen (301, 601) étant adapté pour le codage avec perte dudit signal source, où ledit codage avec perte fournit ledit flux de données codées avec perte (309, 612),
**caractérisé par** ;
- un moyen (302, 602) étant adapté pour le calcul de données de blanchiment spectral (311, 614) à partir des coefficients quantifiés dudit flux de données codées avec perte et des coefficients qui ne sont pas encore quantifiés correspondants reçus à partir dudit codage avec perte, lesdites données de blanchiment spectral représentant une quantification plus précise des coefficients d'origine, où ledit calcul est contrôlé de telle sorte que la puissance de l'erreur quantifiée a pour objectif d'être constante pour toutes les fréquences ;
- un moyen (303, 603) étant adapte pour le décodage avec perte desdites données codées avec perte à l'aide des données de blanchiment spectral, reconstruisant ainsi un signal décodé (312, 615) ;
- un moyen (305, 304, 605, 604) étant adapté pour former un signal de différence (314, 617) entre une version retardée proportionnellement dudit signal source (S_{PCM}) et dudit signal décodé (312, 615) ;
- un moyen (306, 609) étant adapté pour le codage sans perte dudit signal de différence afin de fournir ledit flux de données d'extension sans perte (316, 624) ;
- un moyen (307, 610) étant adapté pour combiner ledit flux de données d'extension sans perte avec ledit flux de données codées avec perte et lesdites données de blanchiment spectral (311, 614) pour former ledit flux de données codées sans perte (317, 625).

4. Appareil selon la revendication 3, où :
- dans ledit moyen de décodage avec perte (603), les informations secondaires (618) sont fournies afin de contrôler un filtre de prédiction dans le domaine temporel ;
- un moyen (607, 608) pour le filtrage de prédiction dudit signal de différence (617) à l'aide des coefficients de filtre (621) qui sont dérivés (606) desdites informations secondaires de façon à décorréler dans le domaine temporel les valeurs consécutives dudit signal de différence (617) ;
- dans ledit moyen de codage sans perte, ledit signal de différence décorrélé (623) est codé (609) à la place dudit signal de différence (314, 617).

5. Procédé pour le décodage d'un flux de données du signal source codé sans perte (S_{PCM}) , lequel flux de données a été dérivé d'un flux de données codées avec perte (309, 612) et d'un flux de données d'extension sans perte (316, 624) qui forment ensemble un flux de données codées sans perte (317, 625) pour ledit signal source, où :
ledit signal source a été codé avec perte (301, 601), ledit codage avec perte fournissant ledit flux de données codées avec perte (309, 612) ;
les données de blanchiment spectral (311, 614) ont été calculées (302, 602) à partir des coefficients quantifiés dudit flux de données codées avec perte et des coefficients qui ne sont pas encore quantifiés correspondants reçus dudit codage avec perte, lesdites données de blanchiment spectral représentant une quantification plus précise des coefficients d'origine, où ledit calcul a été contrôlé de telle sorte que la puissance de l'erreur quantifiée a pour objectif d'être constante pour toutes les fréquences ;
lesdites données codées avec perte ont été décodées avec perte (303, 603) à l'aide desdites données de blanchiment spectral, où un signal décodé (312, 615) a été reconstruit ; un signal de différence (314, 617) a été formé (305, 605) entre une version retardée proportionnellement (304, 604) dudit signal source (S_{PCM}) et dudit signal décodé (312, 615) ; ledit signal de différence a été codé sans perte (306, 609) afin de fournir ledit flux de données d'extension sans perte (316, 624) ; ledit flux de données d'extension sans perte a été combiné (307, 620) avec ledit flux de données codées avec perte et lesdites données de blanchiment spectral (311, 614) pour former ledit flux de données codées sans perte (317, 625) ,
ledit procédé incluant les étapes suivantes :
- le démultiplexage (401, 702) dudit flux de données du signal source codées sans perte (317, 625) afin de fournir ledit flux de données d'extension sans perte (408, 712), ledit flux de données codées avec perte (406, 709) et lesdites données de blanchiment spectral (407, 710) ;
- le décodage avec perte (402, 702) dudit flux de données codées avec perte à l'aide des données de blanchiment spectral (407, 710), reconstruisant ainsi un signal décodé avec perte (409, 719) ;
- le décodage (403, 704) dudit flux de données d'extension sans perte de façon à fournir ledit signal de différence (411, 717) ;
- la combinaison (404, 707) dudit signal de différence (411, 717) avec ledit signal décodé avec perte (409, 719) afin de reconstruire ledit signal source (S_{PCM}).

6. Procédé selon la revendication 5, où du côté du codeur :
dans ledit décodage avec perte (603) desdites données codées avec perte à l'aide desdites données de blanchiment spectral, des informations secondaires (618) pour contrôler un filtre de prédiction dans le domaine temporel sont fournies ;
ledit signal de différence est filtré par le filtre de prédiction (607, 608) à l'aide des coefficients de filtre (621) qui ont été dérivés (606) desdites informations secondaires de façon à décorréler dans le domaine temporel les valeurs consécutives dudit signal de différence ;
- lors du codage sans perte, ledit signal de différence décorrélé (623) a été codé (609) à la place dudit signal de différence (314, 617),
ledit procédé incluant du côté du décodeur en outre les étapes suivantes :
- dans ledit décodage avec perte (702), la mise à disposition des informations secondaires (713) afin de contrôler un filtre de prédiction dans le domaine temporel (705, 706) ;
- le filtrage de dé-corrélation inverse (705, 706) des valeurs consécutives dudit signal de différence décorrélé à l'aide des coefficients du filtre (714) qui sont dérivés (703) desdites informations secondaires (713)
- à la place dudit signal de différence (411), la combinaison (707) dudit signal de différence filtré de décorrélation (718) avec ledit signal décodé avec perte (719) afin de reconstruire ledit signal source (S_{PCM}).

7. Appareil pour le décodage d'un flux de données du signal source codé sans perte (S_{PCM}), lequel flux de données a été dérivé d'un flux de données codées avec perte (309, 612) et d'un flux de données d'extension sans perte (316, 624) qui forment ensemble un flux de données codées sans perte (317, 625) pour ledit signal source, où :
ledit signal source a été codé avec perte (301, 601), ledit codage avec perte fournissant ledit flux de données codées avec perte (309, 612) ;
les données de blanchiment spectral (311, 614) ont été calculées (302, 602) à partir des coefficients quantifiés dudit flux de données codées avec perte et des coefficients qui ne sont pas encore quantifiés correspondants reçus dudit codage avec perte, lesdites données de blanchiment spectral représentant une quantification:plus précise des coefficients d'origine, où ledit calcul a été contrôlé de telle sorte que la puissance de l'erreur quantifiée a pour objectif d'être constante pour toutes les fréquences ;
lesdites données codées avec perte ont été décodées avec perte (303, 603) à l'aide desdites données de blanchiment spectral, où un signal décodé (312, 615) a été reconstruit ; un signal de différence (314, 617) a été formé (305, 605) entre une version retardée proportionnellement (304, 604) dudit signal source (S_{PCM}) et dudit signal décodé (312, 615) ; ledit signal de différence a été codé sans perte (306, 609) afin de fournir ledit flux de données d'extension sans perte (316, 624) ; ledit flux de données d'extension sans perte a été combiné (307, 610) avec ledit flux de données codées avec perte et lesdites données de blanchiment spectral (311, 614) pour former ledit flux de données codées sans perte (317, 625),
ledit dispositif comprenant :
- un moyen (401, 701) étant adapté pour le démultiplexage dudit flux de données du signal source codées sans perte (317, 625) afin de fournir ledit flux de données d'extension sans perte (408, 712), ledit flux de données codées avec perte (406, 709) et lesdites données de blanchiment spectral (407, 710) ;
- un moyen (402, 702) étant adapté pour le décodage avec perte dudit flux de données codées avec perte à l'aide des données de blanchiment spectral (407, 710), reconstruisant ainsi un signal décodé avec perte (409, 719) ;
- un moyen (403, 704) étant adapté pour le décodage dudit flux de données d'extension sans perte de façon à fournir ledit signal de différence (411, 717) ;
- un moyen (404, 704) étant adapté pour la combinaison dudit signal de différence (411, 717) avec ledit signal décodé avec perte (409, 719) afin de reconstruire ledit signal source (S_{PCM}).

8. Appareil selon la revendication 7, où du côté du codeur :
dans ledit décodage avec perte (603) desdites données codées avec perte à l'aide desdites données de blanchiment spectral, des informations secondaires (618) pour contrôler un filtre de prédiction dans le domaine temporel sont fournies ;
ledit signal de différence est filtré par le filtre de prédiction (607, 608) à l'aide des coefficients de filtre (621) qui ont été dérivés (606) desdites informations secondaires de façon à décorréler dans le domaine temporel les valeurs consécutives dudit signal de différence ;
lors du codage sans perte, ledit signal de différence décorrélé (623) a été codé (609) à la place dudit signal de différence (314, 617),
ledit dispositif comprenant :
- dans ledit moyen de décodage avec perte (702), les informations secondaires (713) sont fournies afin de contrôler un filtre de prédiction dans le domaine temporel (705, 706) ;
- un moyen (705, 706) étant adapté pour le filtrage de décorrélation inverse des valeurs consécutives dudit signal de différence décorrélé à l'aide des coefficients du filtre (714) qui sont dérivés (703) desdites informations secondaires (713) ;
- à la place dudit signal de différence (411), la combinaison dans ledit moyen de combinaison (707) dudit signal de différence filtré de décorrélation (718) avec ledit signal décodé avec perte (719) afin de reconstruire ledit signal source (S_{PCM}).

9. Procédé selon la revendication 2 ou 6, ou appareil selon la revendication 4 ou 8, où les données de paramétrage du filtre de prédiction (619) sont dérivées desdites informations secondaires (618) et incluses dans ledit flux de données codées sans perte (625) ou où les données de paramétrage du filtre de prédication des informations secondaires (711) sont extraites dudit flux de données codées sans perte (625) et sont utilisées afin de générer (703) lesdits coefficients de filtrage de prédiction (714), respectivement.

10. Procédé selon le procédé de l'une des revendications 2, 6 et 9, ou appareil selon l'appareil de l'une des revendications 4, 8 et 9, où l'écart-type (620, 715) du résidu de prédiction est utilisé pour paramétrer ledit codage sans perte (609) ou pour contrôler ledit décodage sans perte (704), respectivement.

11. Procédé selon la revendication 1 ou 5, ou appareil selon la revendication 3 ou 7, où les informations secondaires (315, 410) provenant dudit décodeur avec perte (303, 402) sont utilisées pour contrôler ledit codage sans perte (306) ou ledit décodage sans perte (403), respectivement.

12. Procédé selon la revendication 5 ou 6, ou appareil selon la revendication 7 ou 8, où ledit flux de données d'extension sans perte (408, 712) n'est pas évalué et où lesdites données de blanchiment spectral (407, 710) sont utilisées conjointement avec ledit flux de données codées avec perte (406, 709) afin de décoder (402, 702) un signal de sortie ayant une qualité intermédiaire inférieure à celle dudit signal source.

13. Support de stockage, par exemple un disque optique, qui contient ou stocke ou a enregistré un signal numérique codé selon le procédé de l'une des revendications 1, 2 et 9 à 11.
